# EUROPEAN PATENT APPLICATION

(11) **EP 4 235 191 A1**
(43) Date of publication of application: **30.08.2023**
(21) Application number: 21882624.6
(22) Date of filing: 08.10.2021
(51) Int. Cl.: G01R 1/067

(54) **CONTACT PROBE**

(30) Priority: 22.10.2020 JP 2020177213
(71) Applicant: YOKOWO CO., LTD., Kita-ku Tokyo 114-8515 (JP)
(72) Inventor: SATO Kenichi, Tomioka-Shi, Gunma 370-2495 (JP)
(74) Representative: Gunzelmann, Rainer
(86) International application number: PCT/JP2021/037288
(87) International publication number: WO 2022/085483

(57) **Abstract**

Provided is a contact probe (1) comprising: a first plunger (30), which has a distal end section (311) and a proximal end section (33); and a spring (70) which biases the first plunger (30), wherein the surface of the distal end section (311) and the surface of the proximal end section (33) are formed of different metal materials. The distal end section (311) may be 0.1 mm or less in size from the tip.

## Description

### TECHNICAL FIELD

The present invention relates to a contact probe.

### BACKGROUND ART

In inspection of electrical characteristics of an electronic component (a semiconductor device) such as an integrated circuit or a large-scale integrated circuit using semiconductor elements, a contact probe is used to electrically connect the semiconductor device as the inspection object to an inspection substrate. The contact probe includes a plunger for connection to the semiconductor device, and performs an energization test by bringing a tip portion of the plunger into elastic contact with an electrode of the semiconductor device. As the structure of the contact probe, for example, there has been a structure in which a plunger is slidable in a cylindrical barrel (for example, see Patent Literature 1).

### CITATION LIST

### PATENT LITERATURE

Patent Literature 1: JP2019-082378A

### SUMMARY OF INVENTION

### TECHNICAL PROBLEM

The metal material forming the plunger is selected according to the semiconductor device as the inspection object. For example, in the case of a BGA (ball grid array) package, a palladium alloy is generally used to ensure the contact performance with respect to tin (Sn).
However, when a palladium alloy is used for the plunger and the barrel, the contact resistance between the plunger and the barrel is high due to the contact resistance properties of the palladium alloy. Therefore, the conductivity between the plunger and the barrel may be unstable.

An example of an object of the present invention is to improve the conductivity inside a contact probe while ensuring the conductivity between a semiconductor device as the inspection object and the contact probe. Other objects of the present invention will become apparent according to the present description.

### SOLUTION TO PROBLEM

An aspect of the present invention is a contact probe including: a first plunger including a tip portion and a base end portion; and a spring configured to bias the first plunger. A surface of the tip portion and a surface of the base end portion are formed of different metal materials from each other.

According to the above-described aspect of the present invention, it is possible to improve the conductivity inside a contact probe while ensuring the conductivity between a semiconductor device as the inspection object and the contact probe.

### BRIEF DESCRIPTION OF DRAWINGS

Fig. 1 is a diagram illustrating a configuration example of a contact probe:
Fig. 2 is a diagram illustrating a configuration example of a first plunger in a first modification;
Fig. 3 is a diagram illustrating a configuration example of a first plunger in a second modification; and
Fig. 4 is a diagram illustrating a configuration example of a first plunger in a third modification.

### DESCRIPTION OF EMBODIMENTS

Hereinafter, preferred embodiments of the present invention will be described with reference to the drawings. The present invention is not limited to the following embodiments, and forms to which the present invention can be applied are not limited to the following embodiments. In the drawings, the same components are denoted by the same reference signs. As an example, a contact probe 1 of the present embodiment is used such that a semiconductor device as the inspection object is a BGA package and the first plunger 30 comes into contact with a solder ball of the BGA package. The solder ball has tin (Sn).

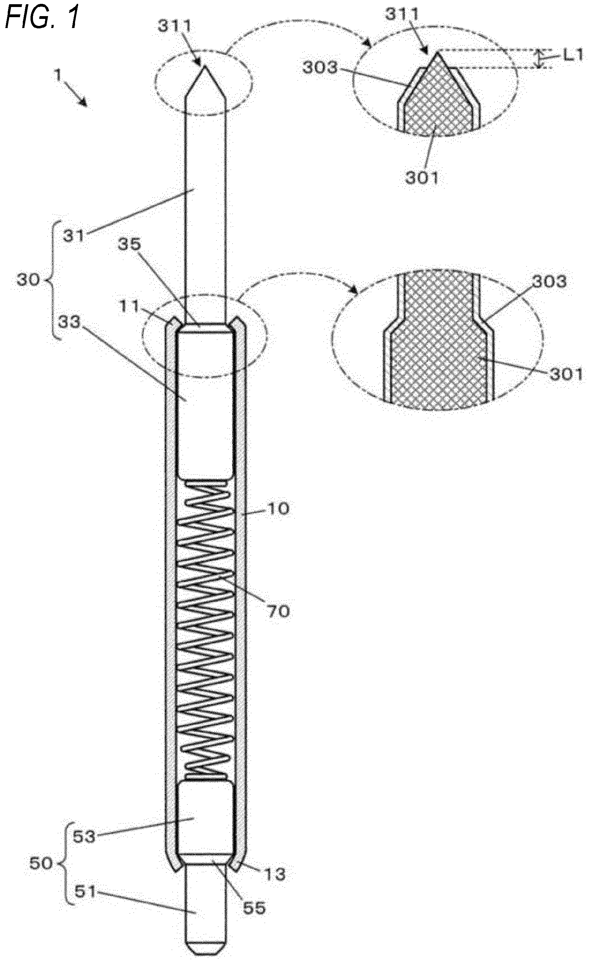

Fig. 1 is a diagram illustrating a configuration example of the contact probe 1 according to the present embodiment, in which a barrel 10 is illustrated in a longitudinal cross section. The contact probe 1 includes the barrel 10, a first plunger 30, a second plunger 50, and a spring 70. In the contact probe 1, due to the spring 70 provided in the barrel 10 and biasing the first plunger 30 and second plunger 50, the first plunger 30 projects from one end of the barrel 10 and the second plunger 50 projects from the other end of the barrel 10.

The barrel 10 is a cylindrical body opened at both ends, and is made of a conductive material such as copper or a copper alloy. Alternatively, the barrel 10 may be obtained by covering, with a conductive material, surfaces (the inner side surface and the outer side surface) of a cylindrical body formed of a nonconductive material. The barrel 10 holds the first plunger 30 at the one end side of the barrel 10 as the upper side in Fig. 1 in a manner slidable in the axial direction, and holds the second plunger 50 at the other end side of the barrel 10 as lower end side in Fig. 1 in a manner slidable in the axial direction. Opening ends at both ends are bent inward to form locking portions 11 and 13, respectively, thereby preventing the first plunger 30 and the second plunger 50 from coming off the barrel 10.

The first plunger 30 includes a projection 31 and a base end portion 33 having a larger diameter than that of the projection 31. A tip portion 311, which is the tip of the projection 31, is a contact portion that comes into contact with the semiconductor device as the inspection object. In Fig. 1, a shape of the tip portion 311 is illustrated as a conical shape. The first plunger 30 is configured to prevent the first plunger 30 from coming off from the barrel 10 to the upper side in Fig. 1 when a tapered stepped portion 35 between the projection 31 and the base end portion 33 comes into contact with the locking portion 11 of the barrel 10. As a result, the base end portion 33 of the first plunger 30 is arranged in the barrel 10 and slides on the inner circumferential surface of the barrel 10. The projection limit length, which is the length by which the tip portion 311 can project most with respect to the barrel 10, can be defined by the length of the projection 31. The length of the projection 31 is designed in accordance with the projection limit length corresponding to the required specification.

The first plunger 30 is made of a conductive material. Specifically, the first plunger 30 is configured such that the surface of the base end portion 33 is formed of gold (Au) and the surface of the tip portion 311 is formed of a metal material other than gold. A longitudinal cross-sectional view of the first plunger 30 in the vicinity of the stepped portion 35 is illustrated as a partially enlarged view surrounded by a one-dot chain line in Fig. 1. The first plunger 30 has a layered configuration in which a surface layer 303 formed of gold is formed as an outermost layer outside a plunger base material 301 as a base material. A longitudinal cross-sectional view of the first plunger 30 in the vicinity of the tip portion 311 is illustrated as a partially enlarged view surrounded by a two-dot chain line in Fig. 1. In the first plunger 30, the surface layer 303 formed of gold is removed from the tip portion 311, and the plunger base material 301 is exposed at the tip portion 311. In this way, the first plunger 30 is configured such that the plunger base material 301 is exposed only at the tip portion 311, and the portions other than the tip portion 311 are covered with the surface layer 303 formed of gold.

In the manufacturing procedure of the first plunger 30, first, the plunger base material 301 is manufactured. In the present embodiment, an alloy of palladium, silver, copper (palladium alloy), or the like is used. Alternatively, for example, a metal material such as beryllium copper can be used. A metal material corresponding to the semiconductor device as the inspection object can be selected.

Next, the surface layer 303 formed of gold is formed on the entire outer side of the plunger base material 301. The surface layer 303 can be formed by surface treatment such as electroplating or hot-dip plating.

Then, the surface layer 303 is removed from the tip portion of the projection 31 to expose the plunger base material 301 on the inner side (that is, the palladium alloy), thereby forming the tip portion 311 whose surface is formed of the palladium alloy. The removal of the surface layer 303 can be realized by processing such as removal by laser or etching, or cutting. More specifically, the portion in contact with the semiconductor device as the inspection object is a portion having a length L1 of 0.1 mm or less from the projection end of the projection 31. For this purpose, for example, a portion within 0.1 mm from projection end of the projection 31 is set as the tip portion 311, and the surface layer 303 of the portion within 0.1 mm is removed, whereby a length of the tip portion 311 is set to a length within 0.1 mm from the projection end of the projection 31. According to this, without exposing the plunger base material 301 (palladium alloy) in an unnecessarily wide range, the cost of removing the surface layer 303 can be reduced.

The range in which the palladium alloy of the plunger base material 301 is exposed is not limited to the tip portion 311 within 0.1 mm from the projection end. For example, the range may be within 0.5 mm or within 1 mm from the projection end of the projection 31. The surface layer 303 formed of gold is only required to be formed at least on the surface of the base end portion 33 that slides on the inner circumferential surface of the barrel 10. Therefore, the surface layer 303 may be removed over the entire region of the projection 31 to expose the palladium alloy.

Alternatively, after the surface layer 303 formed of gold is formed on the entire outer side of the plunger base material 301, a coating layer formed of palladium alloy is formed on the portion within 0.1 mm from the projection end of the projection 31 to become the tip portion 311. In this way, in the first plunger 30, the surface of the tip portion 311 is formed of the palladium alloy, and the surface of the other portions including the base end portion 33 is formed of gold. This configuration may be adopted as well. The coating layer formed of palladium alloy can be formed by surface treatment such as electroplating or hot-dip plating. The plunger base material 301 in this case is not limited to a configuration formed of a metal material such as a palladium alloy, and may be formed of a nonconductive material.

The first plunger 30 can be manufactured without being limited to the method of forming the surface layer 303 formed of gold on the entire outside of the plunger base material 301 and then removing a part thereof, but also by forming the surface layer 303 formed of gold in a partial region on the outer side of the plunger base material 301. For example, the surface of the base end portion 33 may be formed of gold. The forming method may be, for example, a method of forming the surface layer 303 formed of gold on the surface of a large-diameter portion to become the base end portion 33 in the plunger base material 301 by surface treatment such as electroplating or hot-dip plating.

Similarly to the first plunger 30, the second plunger 50 includes a projection 51 and a base end portion 53 having a larger diameter than that of the projection 51. The tip of the projection 51 is in contact with the inspection substrate. The second plunger 50 is configured to prevent the second plunger 50 from coming off from the barrel 10 to the lower side in Fig. 1 when a tapered stepped portion 55 between the projection 51 and the base end portion 53 comes into contact with the locking portion 13 of the barrel 10. As a result, the base end portion 53 of the second plunger 50 is arranged in the barrel 10 and slides on the inner circumferential surface of the barrel 10. The projection limit length, which is the length by which the tip end of the projection 51 can project most with respect to the barrel 10, can be defined by the length of the projection 51. Accordingly, the length of the projection 51 is designed in accordance with the projection limit length corresponding to the required specification.

The second plunger 50 is made of a conductive material. For example, the second plunger 50 has the same layered configuration made of the same metal material as that of the first plunger 30. Alternatively, the second plunger 50 may be made of a metal material different from that of the first plunger 30, or may have a layered configuration different from that of the first plunger 30.

The spring 70 is a coil spring made from a piano wire or a stainless steel wire. The spring 70 is arranged in the barrel 10 and biases the first plunger 30 and the second plunger 50 in directions away from each other along the axial direction of the barrel 10. Accordingly, a contact force for the first plunger 30 to come into contact with the semiconductor device as the inspection object and a contact force for the second plunger 50 to come into contact with the inspection substrate can be applied by a single spring 70.

The contact probe 1 configured as described above is used, for example, by being attached to a socket made of resin. The socket has a plurality of through holes, and each through hole is inserted with the contact probe 1. Between both surfaces of the socket, the tip end side of the first plunger 30 of each contact probe 1 projects from one surface, and the tip end side of the second plunger 50 of each contact probe 1 projects from the other surface. The socket is positioned and placed on the inspection substrate such that the tip of the second plunger 50 (the tip of the projection 51) of each contact probe 1 is in contact with an electrode of the inspection substrate. Then, the semiconductor device as the inspection object is moved toward the socket so that the electrode of the semiconductor device comes into contact with the tip of the first plunger 30 of each contact probe 1 (the tip portion 311 of the projection 31). If the semiconductor device as the inspection object is a BGA package, the BGA package is moved such that the tip portion 311 of the first plunger 30 comes into contact with the solder ball surface of the BGA package. Thus, the semiconductor device as the inspection object and the inspection substrate are electrically connected to each other via the first plunger 30, the barrel 10, the spring 70, and the second plunger 50 of the contact probe 1. Thereafter, electrical inspection is performed on the semiconductor device.

According to the present embodiment, in the contact probe 1 having the structure in which the first plunger 30 on the side in contact with the semiconductor device is movable, the surface of the tip portion 311 of the movable first plunger 30 in contact with the semiconductor device can be formed of a metal material other than gold, and the surface of the base end portion 33 in contact with the barrel can be formed of gold. Specifically, the surface of the tip portion 311 can be formed of a metal material corresponding to the semiconductor device. For example, when the inspection object is a BGA package, the metal material of the surface of the tip portion 311 may be a palladium alloy which has a high contact property with tin (Sn) had in the solder ball. According to this, the contact reliability between the tip portion 311 and the semiconductor device can be increased, and the low contact resistance between the base end portion 33 and the barrel 10 can be ensured. Thus, as compared with the case where the surface of the tip portion 311 and the surface of the base end portion 33 are formed of the same metal material, it is possible to improve the conductivity inside the contact probe 1 while securing the conductivity between the semiconductor device as the inspection object and the contact probe 1.

Embodiments to which the present invention can be applied are not limited to the above-described embodiments, and components may be appropriately added, omitted, or changed.

### First Modification

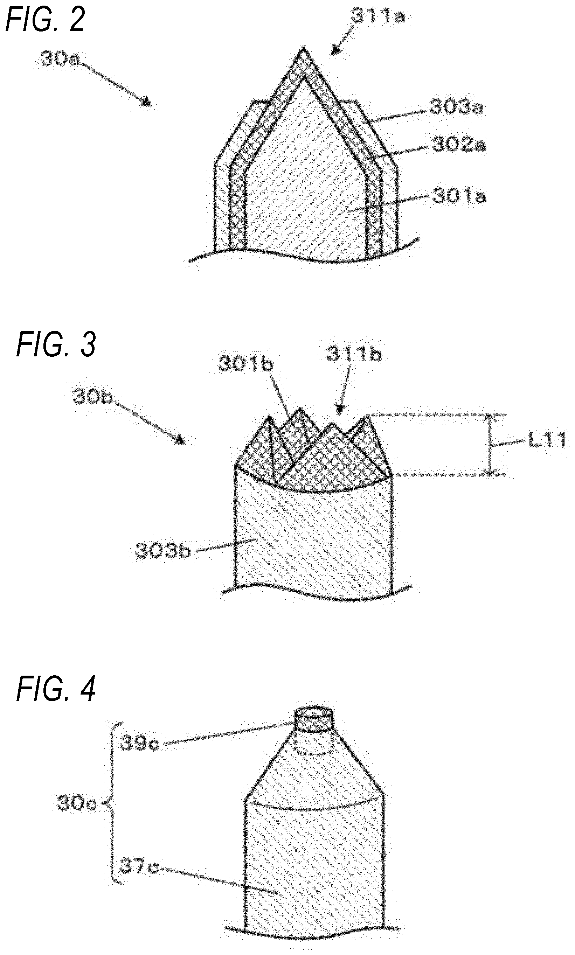

For example, the first plunger may have an inner layer formed of a palladium alloy or the like as the base of a surface layer formed of gold. Fig. 2 is a longitudinal cross-sectional view of the vicinity of a tip portion 311a of a first plunger 30a in the present modification. The first plunger 30a illustrated in Fig. 2 is configured such that the outer side of the plunger base material 301a is formed with an intermediate layer 302a formed of, for example, a palladium alloy as an intermediate layer, and the outer side of the intermediate layer 302a is formed with a surface layer 303a formed of gold as an outermost layer. In the tip portion 311a, the surface layer 303a is removed, and the palladium alloy of the intermediate layer 302a is exposed. The plunger base material 301a is made of, for example, a palladium alloy, beryllium copper, or the like as in the above-described embodiment. The intermediate layer 302a may be formed as a plated coating film mainly having palladium (Pd) and/or rhodium (Rh).

Alternatively, the plunger base material 301a may be formed of a nonconductive material. In this case as well, any layered configuration may be adopted as long as the outer side of the plunger base material 301a is provided with the intermediate layer 302a formed of palladium alloy and the outer side of the intermediate layer 302a is formed with the surface layer 303a formed of gold as the outermost layer, as in the configuration illustrated in Fig. 2.

### Second Modification

In the above-described embodiment, the shape of the tip portion 311 of the first plunger 30 is exemplified as a conical shape, but the shape of the tip portion is not particularly limited. For example, other shapes such as a pyramid shape, a spherical shape, a flat shape, and a crown shape can be appropriately selected depending on the semiconductor device as the inspection object.

Fig. 3 is a perspective view illustrating the vicinity of a tip portion 311b of a first plunger 30b whose tip has a crown shape. When the tip shape is different, the manufacture can be performed by the same procedure as in the above-described embodiments. Specifically, the surface layer 303 formed of gold is formed on the entire outer side of the plunger base material 301b whose tip portion has the corresponding tip shape (crown shape in the example of Fig. 3), and then the plunger base material 301b is exposed by removing the surface layer 303b of the tip portion. The crown-shaped tip portion 311b has a length L11 from the projection end of about 0.05 mm to 0.1 mm. Therefore, for example, similarly to the above-described embodiment, with a portion having a length of 0.1 mm or less from the projection end being the tip portion, the surface layer 303b of the tip portion is removed, whereby the tip portion 311b is set to a length of 0.1 mm or less.

### Third Modification

The first plunger may have an integrated structure in which the portion in contact with the barrel (base end portion) is formed of gold and the tip portion in contact with the semiconductor device is formed of a metal material different from gold. For example, the tip portion may be an embedded member that is embedded in the plunger base material.

Fig. 4 is a perspective view illustrating a tip portion of a first plunger 30c in the present modification. As illustrated in Fig. 4, the first plunger 30c of the present modification includes a plunger body 37c and an embedded member 39c that forms a tip portion, and has a structure in which the embedded member 39c is embedded in the tip of the plunger body 37c. The embedded member 39c is made of a metal material corresponding to the semiconductor device as the inspection object, such as a palladium alloy. On the other hand, the plunger body 37c may have a layered configuration in which a surface layer of gold is formed on the entire outer side of the plunger base material. Alternatively, the plunger body 37c may have a layered configuration in which the inner layer (coating layer) exemplified in the first modification is formed between the plunger base material and the surface layer. The length by which the embedded member 39c projects and is exposed from the tip end of the plunger body 37c can be, for example, a length of 0.1 mm or less as in the above-described embodiments.

Some embodiments and modifications thereof have been described. This disclosure can be summarized as follows.

An aspect of the present disclosure is a contact probe including: a first plunger including a tip portion and a base end portion; and a spring configured to bias the first plunger. A surface of the tip portion and a surface of the base end portion are formed of different metal materials from each other.

According to the aspect of the present disclosure, in the first plunger, the surface of the tip portion for coming into contact with the semiconductor device can be formed of a metal material different from the surface of the base end portion. For example, the surface of the tip portion can be formed of a metal material corresponding to the semiconductor device as the inspection object. Therefore, as compared with the case where the surface of the tip portion and the surface of the base end portion are formed of the same metal material, it is possible to improve the conductivity inside the contact probe while securing the conductivity between the semiconductor device and the contact probe.

The tip portion may have a length within 0.1 mm from a projection end.

Accordingly, the surface can be formed of a metal material different from that of the base end portion while being limited in a range of 0.1 mm from the projection end. At the tip portion, a portion in contact with the semiconductor device as the inspection object is the portion within 0.1 mm from the projection end. Therefore, without forming the surface of the tip portion with a metal material different from that of the surface of the base end portion in an unnecessarily wide range, the cost of forming the surface of the tip portion can be reduced.

The first plunger may have a base material or an inner layer formed of a palladium alloy. The base portion may have an outermost layer formed of gold. The palladium alloy of the base material or the inner layer may be exposed in the tip portion.

Since the surface of the tip portion of the first plunger can be formed of a palladium alloy and the surface of the base end portion can be formed of gold, it is possible to improve the conductivity inside the contact probe while securing the conductivity between the semiconductor device and the contact probe.

The contact probe may further include a second plunger configured to come into contact with an inspection substrate. The spring may bias the first plunger and the second plunger in directions away from each other.

### REFERENCE SIGNS LIST

1: contact probe
10: barrel
30, 30a, 30b, 30c: first plunger
301, 301a, 301b : plunger base material
302a: intermediate layer
303, 303a, 303b : surface layer
311, 311a, 311b : tip portion
37c : plunger body
39c: embedded member
33: base portion
50: second plunger
70: spring

## Claims

1. A contact probe comprising:
a first plunger including a tip portion and a base end portion; and
a spring configured to bias the first plunger, wherein
a surface of the tip portion and a surface of the base end portion are formed of different metal materials from each other.

2. The contact probe according to claim 1, wherein
the tip portion has a length within 0.1 mm from a projection end.

3. The contact probe according to claim 1 or 2, wherein
the first plunger has a base material or an inner layer formed of a palladium alloy,
the base end portion has an outermost layer formed of gold, and
the palladium alloy of the base material or the inner layer is exposed in the tip portion.

4. The contact probe according to any one of claims 1 to 3, further comprising:
a second plunger configured to come into contact with an inspection substrate, wherein
the spring biases the first plunger and the second plunger in directions away from each other.
